# EUROPEAN PATENT APPLICATION

(11) **EP 1 160 923 A2**
(43) Date of publication of application: **05.12.2001**
(21) Application number: 01200470.1
(22) Date of filing: 08.02.2001
(51) Int. Cl.: H01R 12/32, H01R 43/20

(54) **Header for electronic components board in surface mount and through-hole assembly**

(30) Priority: 10.02.2000 US 181701 P
(71) Applicant: Texas Instruments Incorporated, Dallas, Texas 75251 (US)
(72) Inventor: Neild, Kristopher K., Aurora, IL 60504 (US); Fernandez, Claude, Platine, IL 60071 (US); Schaefer, Charles, Crystal Lake, IL 60014 (US)
(74) Representative: Holt, Michael

(57) **Zusammenfassung**

Die Erfindung betrifft einen Strömungsgleichrichter zum Gleichrichten einer Fluidströmung in einer Rohrleitung (1), in der sich mindestens ein Meßgerät (3) befindet, mit einem Gleichrichtelement (4), das eine Vielzahl von Öffnungen (5, 5a) aufweist.

In Abhängigkeit von der Strömungsrichtung wird entweder der maximale Durchströmquerschnitt freigegeben oder der Durchströmquerschnitt teilweise verschlossen. Dies ermöglicht einen Einsatz des Strömungsgleichrichters in bidirektionalen Meßstrecken: Es werden Resonanzprobleme vermieden.

## Description

Die Erfindung betrifft einen Strömungsgleichrichter zum Gleichrichten einer Fluidströmung in einer Rohrleitung, in der sich mindestens ein Meßgerät befindet, mit einem Gleichrichtelement, das eine Vielzahl von Öffnungen aufweist.

Bei dem Meßgerät kann es sich um ein Durchflußmeßgerät, beispielsweise um einen Turbinenradzähler, einen Wirbelzähler, eine Meßblende oder ein Ultraschallmäßgerät handeln.

Um in Rohrleitungen ein optimales Meßergebnis zu erzielen, muß die Strömung möglichst ungestört sein. Dies kann durch sehr lange Einlaufstrecken erreicht werden, wodurch sich Meßstrecken ergeben, deren Abmessungen unakzeptabel groß werden können.

Durch den Einsatz von Strömungsgleichrichtern, die die gestörte Strömung des Fluides gleichrichten, werden kompakte Meßstrecken erreicht.

Aus der Praxis sind Lochplattengleichrichter bekannt, die insbesondere Deformationen des Axialgeschwindigkeitsprofils abbauen. Das Gleichrichtelement ist als Lochplatte ausgebildet, wobei die Bohrungsdurchmesser und die Anordnung der Bohrungen sehr unterschiedlich sein können. Im Einzelfall wird die konstruktive Gestaltung der Lochplatte in Abhängigkeit vom tolerierbaren Druckverlust und der Charakteristik des gestörten Strömungsprofils gewählt.

Bei drallbehafteter Strömung haben sich in der Praxis Gleichrichter bewährt, deren Gleichrichtelement als Rohrbündel ausgebildet ist. Derartige Gleichrichter können bei relativ geringem Druckverlust den Drall der Strömung sehr effektiv abbauen. Die Deformationen des Axialgeschwindigkeitsprofils werden dagegen nur schlecht abgebaut.

Bidirektionale Meßstrecken sind solche Meßstrecken, bei denen sich die Durchflußrichtung von Zeit zu Zeit ändert oder bei denen absehbar ist, daß in der Zukunft eine Durchflußänderung stattfinden wird.

Bei einer bidirektionalen Meßstrecke, bei der Strömungsgleichrichter verwendet werden, befindet sich das Meßgerät zwischen zwei Strömungsgleichrichter, und zwar in symmetrischer Anordnung. Aus Sicherheitsgründen können auch zwei hintereinander geschaltete Meßgeräte verwendet werden.

Versuche haben gezeigt, daß es bei Verwendung von Lochplattengleichrichtern in einer bidirektionalen Meßstrecke zu Geräuschentwicklungen und dadurch insbesondere bei Ultraschallmeßgeräten zu Meßfehlern kommen kann. Diese Geräusche, die teilweise auch außerhalb des Rohres gut hörbar sind, werden durch Schwingungen in der Gassäule erzeugt. Diese Schwingungen sind nur schwer vorhersehbar und nur annäherungsweise berechenbar. Es liegt die Vermutung nahe, daß die starken Schwingungen aufgrund von Resonanzphänomenen zwischen den beiden Gleichrichtern entstehen. Da bei Strömungsgleichrichtem, deren Gleichrichtelement als Lochplatten ausgebildet ist, die Wandbereiche zwischen den Löchern einen erheblichen Teil des Strömungsquerschnittes versperren, können dort möglicherweise Druckwellen reflektiert werden, so daß je nach Reynoldszahl Resonanzen entstehen können.

Die Aufgabe der Erfindung besteht demgemäß darin, einen gattungsgemäßen Gleichrichter derart zu verbessern, daß bei dessen Verwendung in einer bidirektionalen Meßstrecke die Geräuschentwicklung vermieden wird.

Die Aufgabe wird bei einem Strömungsgleichrichter der eingangs genannten Art durch den kennzeichnenden Teil des Anspruches 1 gelöst.

In Abhängigkeit von der Strömungsrichtung wird entweder der maximale Durchströmquerschnitt freigegeben, oder der Durchströmquerschnitt teilweise verschlossen. Dies ermöglicht einen Einsatz des Strömungsgleichrichters in bidirektionalen Meßstrecken: Es werden hier Resonanzprobleme vermieden, da es aufgrund der unterschiedlichen Durchströmquerschnitte nicht zu einer nennenswerten Reflektion von Druckwellen kommt. Vorteilhaft ist weiterhin, daß der Druckverlust in bidirektionalen Meßstrecken deutlich verringert wird.

Die Auswahl der Öffnungen, die verschlossen werden, hängt vom tolerierbaren Druckverlust und der Charakteristik des gestörten Strömungsprofils ab.

Vorzugsweise ist mindestens einer Öffnung eine Schließvorrichtung zugeordnet, die bei Anströmung in eine Richtung öffnet und bei Umkehr der Strömungsrichtung schließt.

Eine vorteilhafte Ausgestaltung der Erfindung besteht darin, daß die Schließvorrichtung als Rückschlagklappe ausgebildet ist.

Alternativ dazu besteht auch die Möglichkeit, die Schließvorrichtung als Kugelschließvorrichtung auszubilden.

Vorteilhafterweise kann das Gleichrichtelement als Lochplatte oder als Rohrbündel ausgebildet sein.

Die Erfindung wird im folgenden anhand bevorzugter Ausführungsbeispiele im Zusammenhang mit der Zeichnung näher erläutert.

Die Zeichnung zeigt in:
Fig. 1 eine schematische Darstellung einer bidirektionalen Meßstrecke;
Fig. 2 eine Vorderansicht eines Lochplattengleichrichters mit dem maximalen freien Durchströmquerschnitt;
Fig. 3 eine Vorderansicht des Lochplattengleichrichters aus Fig. 2 mit einem Teil-Durchströmquerschnitt;
Fig. 4 einen Schnitt durch den Lochplattengleichrichter nach Fig. 1;
Fig. 5 einen Schnitt durch eine andere Ausführungsform eines Lochplattengleichrichters.

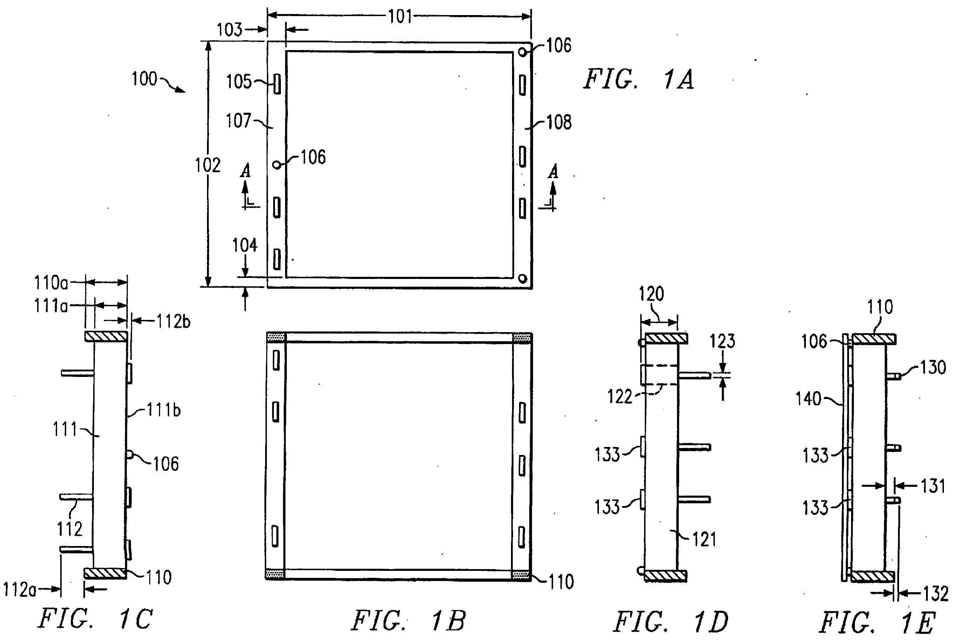

Fig. 1 zeigt eine Meßstrecke 1, in der zwischen zwei Strömungsgleichrichtern 2 zwei hintereinander geschaltete Meßgeräte 3 in Form von Ultraschallzählern angeordnet sind. Es handelt sich um eine bidirektionale Meßstrecke, die sowohl in die eine als auch in die andere Richtung durchströmt werden kann. Bei dem jeweils stromauf liegenden Strömungsgleichrichter ist ein Teil der Öffnungen verschlossen, während bei dem jeweils stromab liegenden Strömungsgleichrichter der maximale Durchströmquerschnitt freigegeben ist.

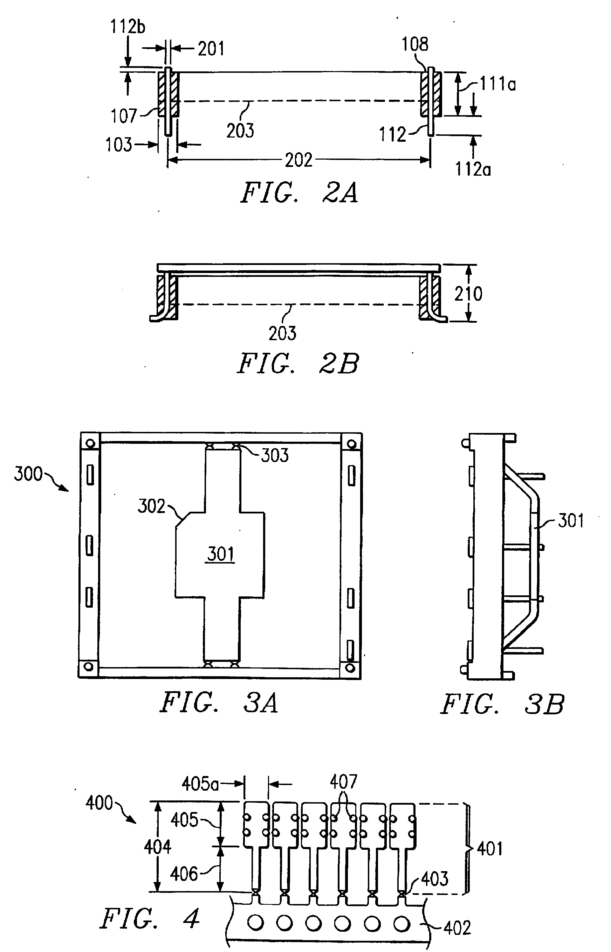

Fig. 2 zeigt ein Gleichrichterelement 4, das eine Vielzahl von gleichmäßig über den Querschnitt verteilten Öffnungen 5 aufweist. Der maximale Durchströmquerschnitt wird freigegeben, wenn alle Öffnungen durchströmt werden.

In Fig. 3 ist das Gleichrichterelement aus Fig. 2 dargestellt, wenn dieses in umgekehrter Richtung durchströmt wird. Die dunkel dargestellten Öffnungen 5a sind verschlossen. In Fig. 4 ist dargestellt, daß jede Öffnung 5a mit einer Schließvorrichtung 6 in Form einer Rückschlagklappe versehen ist, die bei Anströmung in eine Richtung schließt und in Gegenrichtung öffnet.

Bei der Ausführungsform nach Fig. 5 sind die Öffnungen 5a mit Schließvorrichtungen 6 in Form von Kugelschließvorrichtungen versehen. Eine Kugel 7 ist beweglich in einem fluiddurchgängigen Käfig 8 angeordnet und verschließt je nach Strömungsrichtung die Öffnung 5a.

Im Rahmen der Erfindung sind ohne weiteres Abweichungen gegeben. So sind andere Ausführungen der Schließvorrichtung möglich.

## Patentansprüche

1. Strömungsgleichrichter zum Gleichrichten einer Strömung in einer Rohrleitung (1), in der sich mindestens ein Meßgerät (3) befindet, mit einem Gleichrichtelement (4), das eine Vielzahl von Öffnungen (5) aufweist, die einen freien Durchströmquerschnitt bilden,
**dadurch gekennzeichnet, daß** sich der freie Durchströmquerschnitt bei Umkehr der Strömungsrichtung ändert.

2. Strömungsgleichrichter nach Anspruch 1,
**dadurch gekennzeichnet, daß** mindestens einer Öffnung (5) eine Schließvorrichtung (6) zugeordnet ist, die bei Anströmung in eine Richtung öffnet und bei Umkehr der Strömungsrichtung schließt.

3. Strömungsgleichrichter nach Anspruch 2,
**dadurch gekennzeichnet, daß** die Schließvorrichtung (6) als Rückschlagklappe ausgebildet ist.

4. Strömungsgleichrichter nach Anspruch 2,
**dadurch gekennzeichnet, daß** die Schließvorrichtung (6) als Kugelschließvorrichtung ausgebildet ist.

5. Strömungsgleichrichter nach einem der Ansprüche 1 bis 4,
**dadurch gekennzeichnet, daß** das Gleichrichtelement (4) als Lochplatte ausgebildet ist.

6. Strömungsgleichrichter nach einem der Ansprüche 1 bis 4,
**dadurch gekennzeichnet, daß** das Gleichrichtelement (4) als Rohrbündel ausgebildet ist.

7. Anordnung von zwei Strömungsgleichrichtern zwischen denen mindestens ein Meßgerät (3) angeordnet ist
**dadurch gekennzeichnet, daß** bei dem jeweils stromaufliegenden Strömungsgleichrichter der-Durchströmquerschnitt teilweise verschlossen ist und daß bei dem jeweils stromabliegenden Strömungsgleichrichter der maximale Durchströmquerschnitt freigegeben ist.
